# EUROPÄISCHE PATENTSCHRIFT

(11) **EP 3 839 494 B1**
(45) Veröffentlichungstag und Bekanntmachung des Hinweises auf die Patenterteilung: **19.07.2023**
(21) Anmeldenummer: 20214404.4
(22) Anmeldetag: 16.12.2020
(51) Int. Cl.: G01N 27/9013, G01N 27/90

(54) **VERFAHREN ZUR CHARAKTERISIERUNG EINER SCHWEISSNAHT**
METHOD FOR CHARACTERIZATION OF A WELD SEAM
PROCÉDÉ DE CARACTÉRISATION D'UN CORDON DE SOUDURE

(30) Priorität: 16.12.2019 DE 102019219743
(43) Veröffentlichungstag der Anmeldung: 23.06.2021
(73) Patentinhaber: VOLKSWAGEN AG, 38440 Wolfsburg (DE); PLR Prüftechnik Linke & Rühe GmbH, 39126 Magdeburg (DE)
(72) Erfinder: BÖHM, Dennis, 38302 Wolfenbüttel (DE); BREUER, Alexander, 29227 Celle (DE); DILZ, Karsten, 38179 Schwülper (DE); KRAKEN, Mathias, 38102 Braunschweig (DE); SCHÖNEMANN, Malte, 38104 Braunschweig (DE); ZIHRUL, Patrick, 38100 Braunschweig (DE)
(74) Vertreter: FDST Patentanwälte

(56) Entgegenhaltungen:
- WO-A1-2016/185452
- DE-A1- 2 607 783
- DE-A1-102012 025 004
- US-A- 3 693 075
- US-A1- 2002 105 325
- US-A1- 2012 070 721

## Beschreibung

Die Erfindung betrifft ein Verfahren zur Charakterisierung einer Schweißnaht zwischen mindestens zwei Bauteilen. Die Erfindung betrifft weiterhin eine Verwendung des Verfahrens und eine Vorrichtung.

Elektrisch antreibbare oder angetriebene Kraftfahrzeuge, wie beispielsweise Elektro- oder Hybridfahrzeuge, weisen typischerweise einen Elektromotor als Antriebsmaschine auf, welcher zur Versorgung mit elektrischer Energie an einen fahrzeuginternen elektrischen (Hochvolt-)Energiespeicher gekoppelt ist. Derartige Energiespeicher sind beispielsweise in Form von (Fahrzeug-)Batterien ausgeführt.

Unter einer elektrochemischen Batterie ist hierbei insbesondere eine sogenannte sekundäre Batterie (Sekundärbatterie) des Kraftfahrzeugs zu verstehen, bei welcher eine verbrauchte chemische Energie mittels eines elektrischen (Auf-)Ladevorgangs wiederherstellbar ist. Derartige Batterien sind insbesondere als elektro-chemische Akkumulatoren, beispielsweise als Lithium-lonen-Akkumulatoren, ausgeführt. Zur Erzeugung oder Bereitstellung einer ausreichend hohen Betriebsspannung weisen solche Batterien typischerweise mehrere einzelne Batteriezellen auf, welche modular verschaltet sind.

Die Batterien oder Batteriezellen werden beispielsweise aus folienartigen Batterieelektroden hergestellt. Die Batterieelektroden weisen in der Regel eine Aktivmaterialbeschichtung auf, welche auf ein Folienmaterial, insbesondere auf eine Kupfer- oder Aluminiumfolie, aufgetragen ist.

Im Zuge der Herstellung ist es notwendig, dass die Batterieelektroden beziehungsweise beschichteten Folienmaterialien einer Batteriezelle oder einer Batterie mit einem Stromableiter oder einer Ableiterfahne (Busbar, Ableitertab) elektrisch leitfähig verbunden werden. Die Verbindung wird hierbei typischerweise mittels eines Schweißprozesses, beispielsweise mittels eines Laser- oder Ultraschallschweißprozesses, über eine oder mehrere Schweißnähten hergestellt.

Die Güte und Qualität der Schweißverbindung oder der Schweißnaht an den Batteriekomponenten ist relevant für die Qualität der hergestellten Batterie oder Batteriezelle. Zur Reduktion von Ausschussteilen und zur Verbesserung eines Prozessverständnisses ist es daher wünschenswert, die erzeugten Schweißverbindungen oder Schweißnähte an den Batteriekomponenten möglichst zerstörungsfrei und vorzugsweise inline, also während des Herstellungsprozesses in der Herstellungs- oder Produktionslinie, zu untersuchen und/oder zu prüfen.

Eine Charakterisierung, also eine Kontrolle beziehungsweise eine Untersuchung und/oder Prüfung, von Schweißverbindungen ist beispielsweise durch eine Röntgenanalyse, insbesondere mittels einer Computertomographie (CT), oder eine Ultraschallmessung möglich. Nachteiligerweise sind Röntgenmessungen vergleichsweise zeitaufwendig und kostenintensiv, so dass sie nicht inline durchgeführt werden können. Bei Ultraschallmessungen ist insbesondere die Notwendigkeit eines Koppelmediums problematisch, so dass der Inline-Einsatz im Wesentlichen nicht möglich ist. Des Weiteren sind zu Untersuchung und/oder Prüfung der Schweißverbindungen beispielsweise elektrische Widerstandsmessungen über die Schweißnaht denkbar. Elektrische Widerstandsmessungen weisen jedoch eine zu geringe Sensitivität zur Untersuchung von Schweißnähten bei Batteriekomponenten auf. Des Weiteren weisen derartige Widerstandsmessungen lediglich eine geringe Aussagekraft hinsichtlich der mechanischen Belastbarkeit der Schweißnaht aus.

Zur Bewertung der mechanischen Stabilität der Schweißverbindungen sind beispielsweise Abzugtests möglich. Bei einem solchen Abzugtest wird beispielsweise die (Zug-)Festigkeit und das Verformungsverhalten der Schweißnaht bis zu einem Bruch ermittelt. Dadurch wird jedoch die Schweißverbindung, und somit die Batteriezelle oder die Batterie, zerstört, wodurch die Batteriezellen oder Batterien als Ausschussteile nicht verwertbar sind.

Aus den vorstehend genannten Gründen werden Schweißnähte während der Herstellung von Batterieelementen typischerweise nicht inline charakterisiert. Daher wird ein Sicherheitsfaktor bei der Auslegung der Schweißnähte in der Regel hinreichend groß dimensioniert, dass auch bei lediglich sporadischer Kontrolle oder Charakterisierung die Qualität der Schweißnähte gewährleistet ist. Dadurch werden wirtschaftliche Nachteile sowie eine erhöhte Anzahl von Ausschussteilen nach der Produktion oder Herstellung der Batterieelemente herkömmlicherweise in Kauf genommen.

In der US 2002/105325 A1 ist ein Sensor zur Charakterisierung von Schweißnähten bekannt. Der Sensor enthält eine mäanderförmige Antriebswicklung mit mindestens drei verlängerten Abschnitten und mindestens einem Sensorelement, das zwischen einem benachbarten Paar verlängerter Abschnitte angeordnet ist. Ein zeitlich veränderlicher elektrischer Strom wird durch die verlängerten Abschnitte geleitet, um ein Magnetfeld zu erzeugen. Der Sensor wird in der Nähe des Prüfmaterials angebracht und über den Schweißbereich bewegt. Eine elektrische Eigenschaft des Schweißbereichs wird für jede Sensorelementposition gemessen. Die Qualität der Schweißnaht wird anhand der Messung der elektrischen Eigenschaften und der Position bestimmt.

Der Erfindung liegt die Aufgabe zugrunde, ein besonders geeignetes Verfahren zur Herstellung eines Batterieelements anzugeben. Insbesondere soll ein Batteriezellproduktionsprozess optimiert werden. Vorzugsweise soll eine einfache und inlinefähige Untersuchung und/oder Prüfung von Schweißverbindungen zwischen Bauteilen, vorzugsweise zwischen Batteriekomponenten, ermöglicht werden. Der Erfindung liegt weiterhin die Aufgabe zugrunde, eine besonders geeignete Vorrichtung sowie eine besonders geeignete Verwendung anzugeben.

Hinsichtlich des Verfahrens wird die Aufgabe mit den Merkmalen des Anspruchs 1 und hinsichtlich der Verwendung mit den Merkmalen des Anspruchs 6 sowie hinsichtlich der Vorrichtung mit den Merkmalen des Anspruchs 7 erfindungsgemäß gelöst. Vorteilhafte Ausgestaltungen und Weiterbildungen sind Gegenstand der Unteransprüche.

Das erfindungsgemäße Verfahren ist zur Charakterisierung, also zur Kontrolle beziehungsweise zur Untersuchung und/oder (Über-)Prüfung mindestens einer Fügeverbindung zwischen mindestens zwei Bauteilen geeignet und ausgestaltet.

Die Fügeverbindung ist beispielsweise eine Schweißverbindung oder eine vorzugsweise elektrisch leitfähige Klebeverbindung, oder eine mechanische Verbindung, wie beispielsweise eine Verschraubung, oder eine Kombination dieser Verbindungsarten. Nachfolgend wird unter der Fügeverbindung - ohne Einschränkung der Allgemeinheit - insbesondere eine Schweißverbindung verstanden.

Die Bauteile oder Fügepartner sind hierbei beispielsweise mit einer Schweißverbindung stoffschlüssig unter Bildung der mindestens einen Schweißnaht gefügt. Dies bedeutet, dass im Zuge der Schweißverbindung der Bauteile mindestens eine Schweißnaht erzeugt wird. Unter einer "Schweißnaht" sind hier und im Folgenden insbesondere die räumliche Ausdehnung und/oder der räumliche Verlauf der Schweißverbindung beziehungsweise des durch den Schweißprozess bewirkten Stoffschlusses zu verstehen.

Gemäß dem Verfahren wird mindestens ein Wirbelstromsensor mehrmals aufeinanderfolgend über die mindestens eine Fügeverbindung geführt, wobei eine Anzahl von Datensätzen der erfassten Messsignale in unterschiedlichen parallelen Schnittebenen der Schweißnaht erzeugt wird. Anhand der Anzahl von Datensätzen wird anschließend ein Projektionsdatensatz als Maß für die räumliche Verteilung der Messsignale entlang der mindestens einen Fügeverbindung bestimmt. Dadurch ist ein besonders geeignetes Verfahren zur Charakterisierung einer Schweißnaht realisiert.

Verfahrensgemäß wird die oder jede Schweißnaht oder Fügeverbindung somit zerstörungsfrei mittels einer Wirbelstrommessung charakterisiert. Bei einer solchen Wirbelstrommessung wird der Effekt ausgenutzt, dass Verunreinigungen und Beschädigungen, also Defekte oder Fehler, in der elektrisch leitfähigen Schweißnaht deren elektrische Leitfähigkeit oder Permeabilität beeinflussen. Durch die elektromagnetischen Wechselfelder des Wirbelstromsensors, welcher wie oben beschrieben über die Schweißnaht geführt wird, werden in der Schweißnaht Wirbelströme aufgrund der induzierten Spannung erzeugt werden. Der Sensor dient hierbei gleichzeitig als Sender sowie als Empfänger, sodass der Einfluss der oben genannten Defekte in der Schweißnaht auf die induzierten Wirbelströme erfasst wird, wodurch eine einfache und aufwandsreduzierte sowie zerstörungsfreie Untersuchung und/oder Prüfung der oder jeder Schweißnaht ermöglicht ist.

Für die Wirbelstrommessung ist erfindungsgemäß mindestens ein Wirbelstromsensor vorgesehen, welcher entlang der mindestens einen Schweißnaht bewegbar ist, und während einer solchen Bewegung einen Datensatz der erfassten Messsignale erzeugt. Der Wirbelstromsensor erzeugt beispielsweise ein elektromagnetisches Wechselfeld, wobei durch die Bewegung des Wirbelstromsensors entlang der Schweißnaht in dem Material der Schweißnaht elektrische Spannungen und in der Folge Wirbelströme induziert werden. Die Wirbelströme werden mittels des Wirbelstromsensors als Messsignale oder Schwarzwerte erfasst und hieraus ein Datensatz erzeugt. Zur Erfassung der Messsignale weist der Wirbelstromsensor beispielsweise eine Detektionsspule auf, welche den Einfluss der Struktur der Schweißnaht auf die induzierten Ströme erfasst.

Verfahrensgemäß ist es vorgesehen, dass der Wirbelstromsensor mehrmals aufeinanderfolgend entlang der mindestens einen Schweißnaht bewegt wird. Dies bedeutet, dass der Wirbelstromsensor zur Charakterisierung der jeweiligen Schweißnaht mehrmals hintereinander über die zu untersuchende und/oder zu prüfende Schweißstelle geführt wird. Mit anderen Worten wird eine Mehrfachüberfahrt der Schweißnaht mit dem mindestens einen Wirbelstromsensor durchgeführt. Mit jeder Überfahrt wird ein Datensatz der jeweiligen Messdaten oder Messsignale erstellt. Vorzugsweise werden die Messsignale bei unterschiedlichen Überfahrten in unterschiedlichen parallelen Schnittebenen der Schweißnaht erzeugt. Dadurch ist im Wesentlichen eine Wirbelstrom-Abbildung der Schweißnaht realisiert. Dies bedeutet, dass aus den Datensätzen der Überfahrten innere räumliche Strukturen der Schweißnaht, insbesondere Positionen, Verteilung und/oder Intensität von Defekten oder Fehlern, bestimmbar sind. Beispielsweise werden aus den einzelnen Datensätzen jeweils Bilddaten in Form von (zweidimensionalen) Schnittbildern oder Schnittaufnahmen der jeweiligen Schnittebene erzeugt. Zusätzlich oder alternativ sind aus den Datensätzen auch dreidimensionale Bilddaten berechenbar. Fehler und Defekte der Schweißnaht sind hierbei beispielsweise mittels Bilderkennungsalgorithmen in den Bilddaten detektierbar und charakterisierbar.

Vorteilhafterweise ist der Wirbelstromsensor hierbei prüfgerecht ausgeführt, also hinsichtlich seiner Dimensionierung und Ausgestaltung derart an die Batterieelemente angepasst, dass eine zuverlässige und einfache Charakterisierung der Fügeverbindung inline ermöglicht ist. Mit anderen Worten ist die Sensorgeometrie hinsichtlich dem Produktdesign, also abhängig von der Stoßart (Parallelstoß, Stumpfstoß), der Bauteilgeometrie, den elektrischen Kennzahlen und der Form der Fügeverbindung ausgestaltet.

In einer denkbaren Ausführungsform wird die oder jede Schweißnaht mit mehreren Wirbelstromsensoren charakterisiert. Dadurch ist eine schnellere Untersuchung und/oder Prüfung ermöglicht, wodurch Taktzeiten bei der Charakterisierung vorteilhaft reduziert werden. Hierbei ist es beispielsweise denkbar, dass eine Mehrfachüberfahrt der Schweißnaht mit einem Wirbelstromsensor gleichwirkende als einfache Überfahrt mit mehreren Wirbelstromsensoren ausgeführt ist.

Anhand der Anzahl von Datensätzen wird verfahrensgemäß ein Projektionsdatensatz als Maß für die räumliche Verteilung der Messsignale entlang der mindestens einen Schweißnaht bestimmt. Zur Erzeugung des Projektionsdatensatzes werden die einzelnen Datensätze vorzugsweise überlagert oder aufaddiert. Dadurch sind eine einfache Auswertung der Messsignale sowie eine einfache und aufiniandreduzierte Charakterisierung der Schweißnaht ermöglicht. Insbesondere ist die Erzeugung und Auswertung des Projektionsdatensatzes hinsichtlich einer benötigten Rechenleistung beispielsweise im Vergleich zu der Bestimmung eines dreidimensionalen Tomographiedatensatzes wesentlich reduziert.

Die Übertragungsfunktion der Messsignale des Wirbelstromsensors, also der Verlauf der Messsignale bei einem Überstreichen eines beispielsweise punktförmigen Defekts, wie insbesondere einer Pore, einer Fremdphase oder einer Phasengrenze, weist eine wohldefinierte, beispielsweise kreis- oder kreisringförmige, Struktur auf. Durch den Projektionsdatensatz ist somit eine einfache und zuverlässige Charakterisierung der oder jeder Schweißnaht ermöglicht.

Erfindungsgemäß werden die Datensätze der Anzahl von Datensätzen zur Bestimmung des Projektionsdatensatz entlang einer im Wesentlichen senkrecht zu den Schnittebenen orientierten Richtung aufsummiert. Mit anderen Worten wird die Anzahl von Datensätzen zu dem Projektionsdatensatz aufsummiert oder aufaddiert. Es wird also die Dimension der Datensätze effektiv reduziert. Der Projektionsdatensatz ist hierbei vorzugsweise ein lediglich zweidimensionaler Datensatz. Dadurch ist eine besonders einfache und effektive Charakterisierung der oder jeder Schweißnaht realisierbar. Alternativ ist zur Reduktion der Dimension auch ein einzelner Schnitt im Wirbelstromsignal durch das Zentrum der Schweißnaht möglich.

In einer zweckmäßigen Weiterbildung wird ein Kurvenverlauf beziehungsweise eine Fit-Funktion an den Projektionsdatensatz angepasst oder angefittet. Anhand des angepassten Kurvenverlaufs wird die mindestens eine Schweißnaht charakterisiert, wobei eine Bestimmung von Fehlern und/oder Defekten der Schweißnaht erfolgt. Insbesondere werden anhand des Kurvenverlaufs die Position und/oder die Intensität von Fehlern und/oder Defekten der Schweißnaht bestimmt. Dadurch ist ein besonders hoher Informationsgehalt bei der Charakterisierung der Schweißnaht realisiert. In der Folge ist besonders eine einfache und sichere Charakterisierung der Schweißnähte ermöglicht, wodurch eine besonders hohe Qualität des Schweißvorgangs sichergestellt ist.

Darüber hinaus lassen sich ebenfalls Methoden aus dem Bereich der künstlichen Intelligenz verwenden, um eine Auswertung der Messergebnisse zu erlauben. Liegt eine hinreichend gro-ße Datenbasis vor, welche die Wirbelstrommessungen und die entsprechenden Qualitätsparameter (z.B. elektrischer Widerstand und Zugfestigkeit) beinhaltet, lässt sich z.B. ein Convolutional Neural Network antrainieren, welches automatisiert die relevanten Features aus dem Wirbelstromsignal extrahiert.

In einer geeigneten Ausgestaltung wird der Wirbelstromsensor über eine Anzahl von benachbarten Schweißnähten der Bauteile geführt, wobei ein gemeinsamer Projektionsdatensatz als Maß für die räumliche Verteilung der Messsignale entlang der Schweißnähte bestimmt wird. Mit anderen Worten werden die Datensätze oder Messsignale beziehungsweise Schwarzwerte über mehrere Schweißnähte zu dem gemeinsamen Projektionsdatensatz aufsummiert oder aufaddiert. Dies bedeutet, dass die Anzahl von benachbarten Schweißnähten vorzugsweise nicht einzeln sondern gemeinsam charakterisiert wird. Dadurch ist eine besonders einfache, zeitreduzierte sowie rechenleistungsreduzierte Charakterisierung ermöglicht.

In einer bevorzugten Ausbildung wird der Projektionsdatensatz mit einem hinterlegten Referenzdatensatz verglichen. Der Referenzdatensatz ist hierbei insbesondere ein Datensatz von Referenz-Schwellwerten einer Beispiel- oder Referenz-Schweißnaht oder Bauteilprobe. Die Referenz-Schwellwerte beziehen sich hierbei beispielsweise insbesondere auf die Position und/oder die Intensität eines Defekts und/oder Fehlers der Schweißnaht. In einer denkbaren Ausbildungsform ist es möglich, dass die gefügten Bauteile als Ausschussteil charakterisiert werden, wenn ein Fehler und/oder Defekt im Projektionsdatensatz einen oder mehrere Referenz-Schwellwerte des Referenzdatensatzes erreicht oder überschreitet. Dadurch ist ein besonders einfaches und zweckmäßiges Verfahren für einen Serieneinsatz realisiert.

In einer vorteilhaften Ausführung wird der mindestens eine Wirbelstromsensor bei aufeinanderfolgenden Bewegungen oder Überfahrten entlang der Schweißnaht verkippt und/oder verschwenkt. Dadurch werden die Schnittebenen, in welchen die Messsignale erzeugt und detektiert werden ebenfalls verkippt oder verschwenkt, also um einen Winkel geneigt. Dadurch wird die räumliche Auflösung im Zuge der Untersuchung und/oder Prüfung der mindestens einen Schweißnaht verbessert, wodurch eine genauere und effektivere Bestimmung von Fehlern und/oder Defekten ermöglicht ist.

In einer bevorzugten Anwendung wird das vorstehend beschriebene Verfahren in einem Herstellungsverfahren eines Batterieelements verwendet. Dies bedeutet, dass das erfindungsgemäße Verfahren vorzugsweise bei einer Herstellung eines Batterieelements, wie beispielsweise einer Batteriezelle oder einer Batterie, verwendet wird. Grundsätzlich kann das Verfahren aber auch bei anderen geschweißten Bauteilen eingesetzt werden, bei welchen mindestens eine Schweißnaht kontrolliert werden soll. Die im Hinblick auf das Verfahren angeführten Vorteile und Ausgestaltungen sind sinngemäß auch auf die Verwendung übertragbar und umgekehrt.

Bei der Herstellung des Batterieelements werden mindestens zwei benachbart angeordnete Batteriekomponenten als Bauteile mit einer Schweißverbindung gefügt.

Beispielsweise sind die Batteriekomponenten hierbei übereinander gestapelt angeordnet, dies bedeutet, dass mindestens zwei Batteriekomponenten abschnittsweise überlappend angeordnet sind, wobei die Schweißverbindung insbesondere in dem überlappenden Bereich bewirkt wird. Alternativ ist es beispielsweise ebenso denkbar, dass die Batteriekomponenten auf Parallelstoß oder nebeneinander (Stumpfstoß) angeordnet sind.

Im Zuge der Schweißverbindung wird somit mindestens eine Schweißnaht erzeugt. Die mindestens eine Schweißnaht wird hierbei mittels des vorstehend beschriebenen Verfahrens charakterisiert. Durch das erfindungsgemäße Charakterisierungsverfahren wird das Herstellungsverfahren der Batterieelemente wesentlich verbessert. Insbesondere ist somit eine einfache und kostengünstige sowie zerstörungsfreie Untersuchung und/oder Prüfung von Schweißverbindungen zwischen den Batteriekomponenten ermöglicht.

Die gefügten oder verschweißten Batteriekomponenten sind insbesondere Folienelemente des Batterieelements. Bei dem Schweißprozess werden beispielsweise eine oder mehrere Batterieelektroden mit einem Stromableiter oder einer Ableiterfahne oder einer Busbar kontaktiert und verbunden.

In einer bevorzugten Ausführung wird die Charakterisierung der mindestens einen Schweißnaht, also die Wirbelstromuntersuchung, inline durchgeführt. Dies bedeutet, dass die Wirbelstrommessung Hinsichtlich der Herstellung des Batterieelements prozessintegriert ausgeführt ist. Die Wirbelstrommessung wird also im Zuge der Herstellungs- oder Produktionslinie, beispielsweise "on-the-fly" durchgeführt, wodurch eine besonders gleichförmige Produktion und Herstellung des Batterieelements ermöglicht ist.

Durch die Inline-Wirbelstrommessung zur Charakterisierung oder Kontrolle der Schweißnähte werden Ausschussteile reduziert, wodurch in der Folge Produktions- und Herstellungskosten des Batterieelements vorteilhaft reduziert werden. Insbesondere ist somit eine Vollautomatisierung der Untersuchung und/oder Prüfung ermöglicht, welche vorzugsweise im Produktionstakt erfolgt.

Des Weiteren ermöglicht die Inline-Wirbelstrommessung eine automatische Rückkopplung in die Prozess-Parametrierung und eine verbesserte Prozessregelung durch die Schweißnaht-Charakterisierung. Dadurch ist beispielsweise ein Soll-Ist-Vergleich zur Überprüfung der Maßhaltigkeit oder Formänderung der erzeugten Schweißnähte ermöglicht, beispielsweise durch einen Vergleich mit einem Referenzdatensatz. Weiterhin wird somit das Prozessverständnis bei der Erzeugung der Schweißverbindungen verbessert, was einer Verbesserung der Schweißnahtqualität und somit der Qualität der Batterieelemente zuträglich ist.

Die erfindungsgemäße Vorrichtung ist zur Herstellung eines Batterieelements, insbesondere zur Herstellung einer Batterie oder einer Batteriezelle, geeignet und eingerichtet. Die Vorrichtung weist hierbei eine Schweißeinrichtung zur stoffschlüssigen Schweißverbindung von mindestens zwei übereinander gestapelt angeordneten Batteriekomponenten auf. Die Schweißeinrichtung ist beispielsweise für ein Ultraschallschweißen oder ein Laserstrahlschweißen geeignet und eingerichtet. Die zu fügenden oder zu verschweißenden Batteriekomponenten sind beispielsweise eine Batterieelektrode und ein Stromableiter beziehungsweise ein Ableitertab oder ein Busbar. Die Vorrichtung weist weiterhin einen Wirbelstromsensor zur Erzeugung und Erfassung von Wirbelströmen im Bereich mindestens einer durch die Schweißeinrichtung erzeugten Schweißnaht auf. Die Schweißeinrichtung und der Wirbelstromsensor sind mit einem Controller, das heißt mit einer Steuereinheit, gekoppelt. Dadurch ist eine besonders geeignete Vorrichtung zur Herstellung von Batterieelementen realisiert.

Die im Hinblick auf das Verfahren und/oder die Verwendung angeführten Vorteile und Ausgestaltungen sind sinngemäß auch auf die Vorrichtung übertragbar und umgekehrt.

Der Controller ist hierbei allgemein - programm- und/oder schaltungstechnisch - zur Durchführung des vorstehend beschriebenen erfindungsgemäßen Verfahrens beziehungsweise Verwendung eingerichtet. Der Controller ist somit konkret dazu eingerichtet, nach einem Schweißprozess der Schweißeinrichtung mittels des Wirbelstromsensors Wirbelströme in der Schweißnaht beziehungsweise im Bereich der Schweißnaht zu induzieren, und diese Wirbelströme beziehungsweise die Verteilung und Intensität der Wirbelströme in der Schweißnaht oder dem Bereich zu erfassen und auszuwerten. Der Controller ist insbesondere dazu geeignet und eingerichtet, den Herstellungs- oder Produktionsprozess des Batterieelements anhand der charakterisierten Schweißnaht zu steuern und/oder zu regeln.

In einer bevorzugten Ausgestaltungsform ist der Controller zumindest im Kern durch einen Mikrocontroller mit einem Prozessor und einem Datenspeicher gebildet, in dem die Funktionalität zur Durchführung des erfindungsgemäßen Verfahrens in Form einer Betriebssoftware (Firmware) programmtechnisch implementiert ist, so dass das Verfahren - gegebenenfalls in Interaktion mit einem Vorrichtungsnutzer - bei Ausführung der Betriebssoftware in dem Mikrocontroller automatisch durchgeführt wird. Der Controller kann im Rahmen der Erfindung alternativ aber auch durch ein nicht-programmierbares elektronisches Bauteil, wie zum Beispiel einem anwendungsspezifischen integrierten Schaltkreis (ASIC), gebildet sein, in dem die Funktionalität zur Durchführung des erfindungsgemäßen Verfahrens mit schaltungstechnischen Mitteln implementiert ist.

In einer bevorzugten Ausgestaltung ist der Wirbelstromsensor als ein Gabelsensor in Transmissionsgeometrie, also als ein Transmissions-Gabelsensor, ausgeführt. Dadurch ist ein besonders zweckmäßiger Wirbelstromsensor realisiert.

Der Gabelsensor weist hierbei beispielsweise ein etwa hufeisenförmiges oder U-förmiges (Sensor-)Gehäuse auf, wobei im Bereich der Freienden der vertikalen U-Schenkel eine Sendespule und eine gegenüberliegend angeordnete Empfängerspule angeordnet sind. Die Spulen sind hierbei geeigneterweise in einem transformatorischen Prinzip mit dem Controller verbunden. Die Erregerfrequenz der Spulen, also die Frequenz des bei Bestromung der Spulen erzeugten magnetischen Feldes, ist hierbei derart gewählt, dass eine ausreichende Durchdringung des elektrisch leitenden Materials der Schweißverbindung gewährleistet ist.

Zur Untersuchung der Schweißverbindung wird das Batterieelement im Bereich der Gabelöffnung (Maulöffnung) zwischen die Schenkel eingeführt. Durch die Gabelform ist der Wirbelstromsensor hierbei einfach entlang der Schweißverbindung bewegbar und/oder verschwenkbar.

Die nicht erfindungsgemäße Fahrzeugbatterie ist insbesondere als eine Traktionsbatterie eines elektrisch angetriebenen oder antreibbaren Kraftfahrzeugs, beispielsweise eines Elektro- oder Hybridfahrzeugs, geeignet und eingerichtet. Die Fahrzeugbatterie weist mindestens ein Batterieelement auf, welches nach dem vorstehend beschriebenen Verfahren beziehungsweise nach der vorstehend beschriebenen Verwendung des Verfahrens hergestellt ist. Dadurch ist eine besonders geeignete Fahrzeugbatterie realisiert. Insbesondere überträgt sich die aufgrund des Verfahrens besonders hohe Schweißnaht-Qualität des Batterieelements vorteilhaft auf die Qualität der Fahrzeugbatterie, wodurch deren Reichenweite und Lebensdauer verbessert ist.

Die im Hinblick auf das Verfahren und/oder die Verwendung und/oder die Vorrichtung angeführten Vorteile und Ausgestaltungen sind sinngemäß auch auf die Fahrzeugbatterie übertragbar und umgekehrt.

Nachfolgend sind Ausführungsbeispiele der Erfindung anhand einer Zeichnung näher erläutert. Darin zeigen in vereinfachten und schematischen Darstellungen:
- Fig. 1: in Draufsicht eine Vorrichtung zur Herstellung eines Batterieelements,
- Fig. 2 bis Fig. 4: in Draufsicht jeweils das Batterieelement mit einem Ableitertab und einer Kollektorfolie, welche mittels einer Anzahl von Schweißnähten stoffschlüssig verbunden sind,
- Fig. 5: in mehreren Teil-Darstellungen ein erfindungsgemäßes Verfahren zur Charakterisierung mindestens einer Schweißnaht, und
- Fig. 6, Fig. 7: in Perspektive einen als Gabelsensor ausgeführten Wirbelstromsensor zur Untersuchung der Schweißnaht.

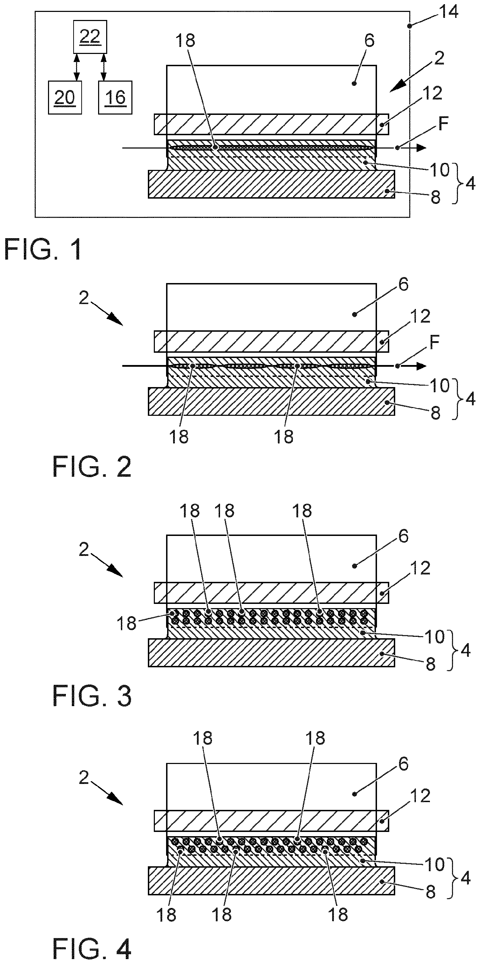

In den Figuren 1 bis 4 ist jeweils ein Batterieelement 2 einer nicht näher dargestellten Fahrzeugbatterie gezeigt. Das Batterieelement 2 weist zwei Batteriekomponenten 4, 6 als Bauteile auf.

Das Batterieelement 2 ist beispielsweise eine Batteriezelle, wobei die Batteriekomponente 4 hierbei insbesondere als eine Batterieelektrode mit einer Beschichtung 8 und einer Kollektorfolie 10, und wobei die Batteriekomponente 6 insbesondere als ein Ableitertab ausgeführt ist. Zur verbesserten Anbindung im Bereich der Batteriekomponente beziehungsweise des Ableitertabs 6 und einem nicht näher gezeigten Gehäuseteil des Batterieelements 2 ist ein sogenanntes Vorsiegelband 12 im Bereich der Batteriekomponente 6 angeordnet. Mittels des Vorsiegelbands 12 ist ein Mindestabstand zur elektrischen Isolation zwischen den Spannung führenden Ableitertab 6 und dem Gehäuseteil realisiert.

In der Fig. 1 ist weiterhin in schematischer und stark vereinfachter Darstellung eine Vorrichtung 14 zur Herstellung des Batterieelements 2 gezeigt.

Die Vorrichtung 14 weist hierbei eine Schweißeinrichtung 16 zur stoffschlüssigen Schweißverbindung der zumindest abschnittsweise übereinander gestapelt angeordneten Batteriekomponenten 4 und 6 auf. Die Schweißeinrichtung 16 ist beispielsweise für ein Ultraschallschweißen oder ein Laserstrahlschweißen geeignet und eingerichtet. Die Schweißeinrichtung 16 wird hierbei beispielsweise entlang einer Fügerichtung F bewegt, und dabei die Batteriekomponenten 4, 6 mittels mindestens einer Fügeverbindung oder Schweißnaht 18 stoffschlüssig gefügt.

Die Vorrichtung 14 weist weiterhin einen Wirbelstromsensor 20 zur Charakterisierung oder Kontrolle der mindestens einen Schweißnaht 18 auf. Der Wirbelstromsensor 20 ist hierbei zur Erzeugung und Erfassung von Wirbelströmen im Bereich der mindestens einen Schweißnaht 18 geeignet und eingerichtet.

Die Schweißeinrichtung 16 und der Wirbelstromsensor 20 sind mit einem Controller 22, das heißt mit einer Steuereinheit, gekoppelt.

In dem Ausführungsbeispiel der Fig. 1 weist das Batterieelement 2 eine einzige, längliche Schweißnaht 18 auf. Mit anderen Worten sind die Batteriekomponenten 4 und 6, insbesondere das Ableitertab 6 und die Kollektorfolie 10, mittels einer Schweißnaht 18 miteinander verschweißt.

Das Ausführungsbeispiel der Fig. 2 zeigt das Batterieelement 2 mit vier entlang der Fügerichtung F verteilt angeordneten, länglichen Schweißnähten 18. In den in der Fig. 3 und in der Fig. 4 gezeigten Ausführungsbeispielen sind die Batteriekomponenten 4 und 6 jeweils mit einer Anzahl von etwa punktförmigen Schweißnähten (Schweißpunkte) 18 verbunden, welche beispielsweise in zwei Reihen senkrecht zur Fügerichtung F verteilt angeordnet sind. In dem Ausführungsbeispiel der Fig. 3 sind die Reihen hierbei übereinander gestapelt angeordnet, wobei in dem Ausführungsbeispiel der Fig. 4 die Reihen gegeneinander auf Lücke versetzt angeordnet sind. Die Schweißnähte 18 sind in den Figuren lediglich beispielhaft mit Bezugszeichen versehen.

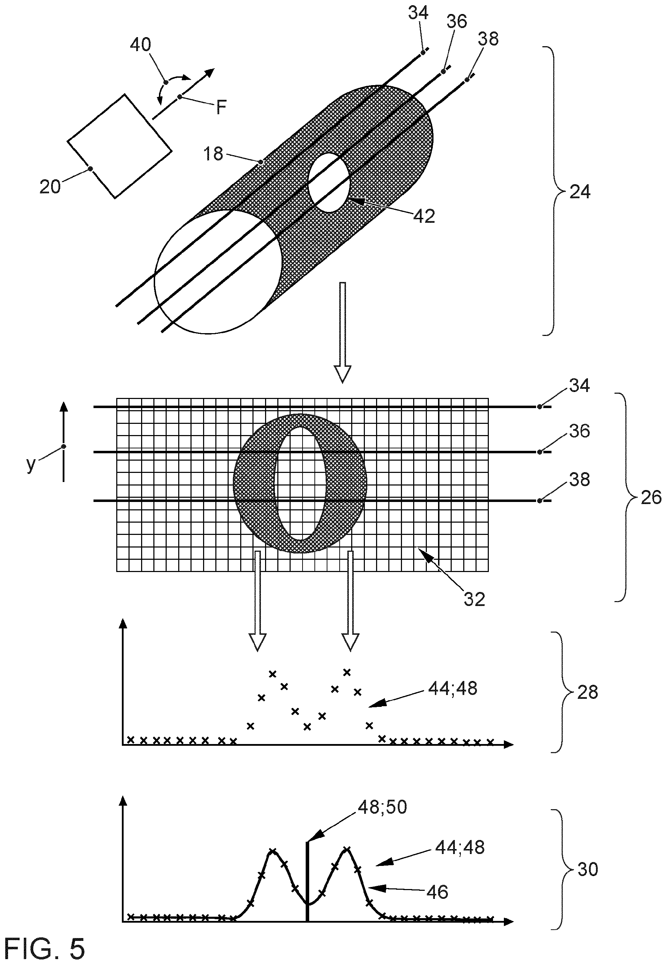

Nachfolgend ist anhand der Fig. 5 ein erfindungsgemäßes Verfahren zur Charakterisierung oder Kontrolle mindestens einer Schweißnaht 18 näher erläutert. Die Darstellung der Fig. 5 weist vier horizontal übereinander angeordnete Abschnitte 24, 26, 28 und 30 auf. In den Abschnitten ist jeweils ein Verfahrensschritt zur Charakterisierung der mindestens einen Schweißnaht 18 gezeigt.

In dem in Abschnitt 24 gezeigten ersten Verfahrensschritt wird der Wirbelstromsensor 20 mehrmals aufeinanderfolgend entlang der mindestens einen Schweißnaht 18 bewegt. Der Wirbelstromsensor 20 wird hierbei insbesondere linear entlang der Fügerichtung F bewegt und hierbei mehrmals hintereinander über die zu untersuchende und/oder zu prüfende Schweißstelle geführt. Die Messdaten oder Messsignale (Sensorsignale) 32 werden an den Controller 22 zur Auswertung versendet.

Mit jeder Überfahrt wird ein Datensatz der jeweiligen Messsignale 32 erstellt und in einem Speicher des Controllers 22 hinterlegt. Die Messsignale 32 werden bei unterschiedlichen Überfahrten in unterschiedlichen parallelen Schnittebenen 34, 36, 38 der Schweißnaht 18 erzeugt, wobei in der Fig. 5 beispielhaft drei Schnittebenen 34, 36 und 38 gezeigt sind.

Der Wirbelstromsensor 20 wird bei aufeinanderfolgenden Bewegungen oder Überfahrten entlang der Schweißnaht 18 beispielsweise verkippt und/oder verschwenkt. Dies ist in dem Abschnitt 24 schematisch mittels eines Doppelpfeils 40 gezeigt.

Die in der Fig. 5 gezeigte Schweißnaht 18 weist einen etwa punktförmigen Defekt 42 auf. Der Defekt 42 ist beispielsweise eine Pore, eine Fremdphase oder eine Phasengrenze innerhalb der Schweißnaht 18. Die im Abschnitt 26 gezeigte Übertragungsfunktion der Messsignale 32 des Wirbelstromsensors 20, also der Verlauf der Messsignale 32 bei einem Überstreichen des Defekts 42, weist eine wohldefinierte, beispielsweise kreis- oder kreisringförmige, Struktur auf.

In einem darauffolgenden Verfahrensschritt wird von dem Controller 22 ein in Abschnitt 28 gezeigter Projektionsdatensatz 44 durch eine Überlagerung der Datensätze der Messsignale 32 aus den einzelnen Schnittebenen 34, 36, 38 erzeugt. Hierzu werden die Messsignale 32 oder Schwarzwerte der der Anzahl von Datensätzen entlang einer im Wesentlichen senkrecht zu den Schnittebenen orientierten Richtung y aufsummiert. Mit anderen Worten wird die Anzahl von Datensätzen zu dem Projektionsdatensatz 44 aufsummiert oder aufaddiert. Es wird also die Dimension der Datensätze effektiv reduziert. Wie im Abschnitt 28 ersichtlich ist der Projektionsdatensatz 44 im Wesentlichen ein zweidimensionaler Datensatz in einer senkrecht zur Längs-oder Fügerichtung F orientierten Ebene.

In dem in Abschnitt 30 gezeigten Verfahrensschritt wird von dem Controller 22 ein Kurvenverlauf oder Fit 46 an die Daten des Projektionsdatensatzes 44 angepasst oder angefittet. Anhand des angepassten Kurvenverlaufs 46 wird die Schweißnaht 18 charakterisiert, wobei eine Bestimmung der Position und/oder Intensität des Defekts 42 innerhalb der Schweißnaht 18 erfolgt.

Zum Anpassen oder Anfitten des Kurvenverlaufs 46 werden vorzugsweise eine Anzahl gleichmäßig verteilter Funktionen verwendet, welche sich aus der Form der wohldefinierten Struktur ergeben. In dem gezeigten Ausführungsbeispiel folgt aus der kreis- oder kreisringförmigen Struktur der Messsignale 32 (Abschnitt 26) ein etwa kamelhöckerartiger Kurvenverlauf 46.

In dem dargestellten Ausführungsbeispiel werden zum Anpassen oder Anfitten des Kurvenverlaufs 46 beispielsweise zwei nebeneinander angeordnete Gauß-Peaks verwendet, deren Abstand zueinander lediglich in einem wohldefinierten Bereich liegt.

Aus der Intensität oder Amplitude des Kurvenverlaufs 46 an die Formen der Daten des Projektionsdatensatzes 44 ist der Controller 22 dazu geeignet und eingerichtet an der jeweiligen Position wesentliche Eigenschaften des Defekts 42, insbesondere dessen Dimension 48 und/oder Position 50 innerhalb der Schweißnaht 18, einfach zu bestimmen. Dadurch ist eine einfache Auswertung von Messsignalen 32 auch bei dicht benachbarten Defekten 42 möglich, wobei die Defekte 42 durch die Anzahl von Fit-Funktionen im Wesentlichen einzeln auflösbar sind.

Der Kurvenverlauf 46 und/oder der Projektionsdatensatz 44 werden beispielsweise von dem Controller 22 mit einem hinterlegten Referenzdatensatz für Schwellwerte einer Referenz- oder Beispielprobe verglichen. Vorzugsweise erfolgt hierbei eine Charakterisierung des Signals beziehungsweise Kurvenverlaufs 46 über z.B. neuronale Netzwerke.

Der Controller 22 steuert und/oder regelt den Herstellungsprozess der Batterieelemente 2 vorzugsweise anhand der Charakterisierung der erzeugten Schweißnähte 18. Hierbei ist es möglich, dass das Batterieelement 2 als Ausschussteil charakterisiert wird, wenn anhand eines Schwellwertvergleichs mit den Referenzdatensatz beispielsweise ein intensiver Defekt 42 im Projektionsdatensatz 44 und/oder dem Kurvenverlauf 46 erkannt wird.

Bei einer Anzahl von Schweißnähten 18 - wie beispielsweise in den Ausführungsbeispielen der Figuren 2 bis 4 - ist es möglich, dass der Wirbelstromsensor 20 entlang der Fügerichtung F über eine Anzahl von benachbarten Schweißnähte 18 geführt wird. Der Controller 22 bestimmt hierbei geeigneterweise einen gemeinsamen Projektionsdatensatz 48 als Maß für die räumliche Verteilung der Messsignale 32 entlang der Schweißnähte 18, welcher entsprechend zu dem vorstehend beschriebenen Projektionsdatensatz 44 einer einzelnen Schweißnaht 18 ausgewertet wird.

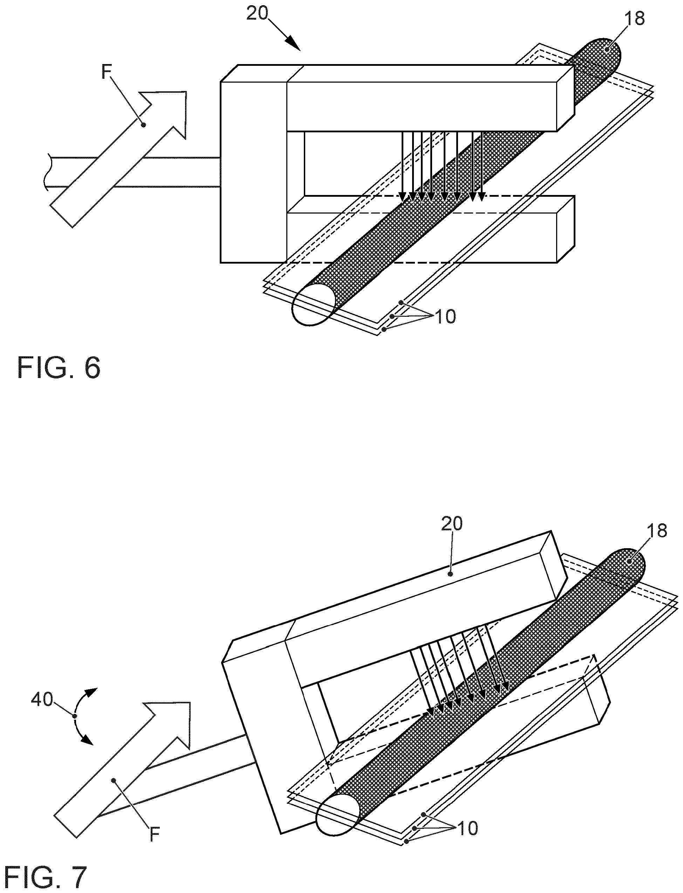

In den Figuren 6 und 7 ist eine Ausführungsbeispiel des Wirbelstromsensors 20 in Form eines Transmissions-Gabelsensors gezeigt.

Der Gabelsensor 20 weist hierbei beispielsweise ein etwa hufeisenförmiges oder U-förmiges (Sensor-)Gehäuse 50 auf, wobei im Bereich der vertikalen U-Schenkel eine Sendespule und eine gegenüberliegend angeordnete Empfängerspule angeordnet sind. Die nicht näher gezeigten Spulen sind hierbei in einem transformatorischen Prinzip mit dem Controller verbunden. Die Erregerfrequenz der Spulen ist hierbei derart gewählt, dass eine ausreichende Durchdringung des elektrisch leitenden Materials der Schweißverbindung 18 gewährleistet ist.

Die beanspruchte Erfindung ist nicht auf die vorstehend beschriebenen Ausführungsbeispiele beschränkt. Vielmehr können auch andere Varianten der Erfindung von dem Fachmann hieraus im Rahmen der offenbarten Ansprüche abgeleitet werden, ohne den Gegenstand der beanspruchten Erfindung zu verlassen. Insbesondere sind ferner alle im Zusammenhang mit den verschiedenen Ausführungsbeispielen beschriebenen Einzelmerkmale im Rahmen der offenbarten Ansprüche auch auf andere Weise kombinierbar, ohne den Gegenstand der beanspruchten Erfindung zu verlassen.

### Bezugszeichenliste

- 2: Batterieelement
- 4: Batteriekomponente/Bauteil
- 6: Batteriekomponente/Bauteil/Ableitertab
- 8: Beschichtung
- 10: Kollektorfolie
- 12: Vorsiegelband
- 14: Vorrichtung
- 16: Schweißeinrichtung
- 18: Fügeverbindung/Schweißnaht
- 20: Wirbelstromsensor/Gabelsensor
- 22: Controller
- 24, 26, 28, 30: Abschnitt
- 32: Messsignale
- 34, 36, 38: Schnittebene
- 40: Pfeil
- 42: Defekt
- 44: Projektionsdatensatz
- 46: Kurvenverlauf
- 48: Projektionsdatensatz
- 50: Gehäuse

- F: Fügerichtung
- y: Richtung

## Patentansprüche

1. Verfahren zur Charakterisierung mindestens einer Fügeverbindung (18), insbesondere einer Schweißnaht, zwischen mindestens zwei gefügten Bauteilen (4, 6),
- wobei ein Wirbelstromsensor (20) mehrmals aufeinanderfolgend entlang der mindestens einen Fügeverbindung (18) geführt wird, wobei eine Anzahl von Datensätzen der erfassten Messsignale (32) in unterschiedlichen parallelen Schnittebenen (34, 36, 38) der Fügeverbindung (18) erzeugt wird,
- wobei anhand der Anzahl von Datensätzen ein Projektionsdatensatz (44, 48) als Maß für die räumliche Verteilung der Messsignale (32) entlang der mindestens einen Fügeverbindung (18) bestimmt wird, und
- wobei die Datensätze zur Bestimmung des Projektionsdatensatz (44, 48) entlang einer senkrecht zu den Schnittebenen (34, 36, 38) orientierten Richtung (y) aufsummiert werden.

2. Verfahren nach Anspruch 1,
**dadurch gekennzeichnet,**
**dass** ein Kurvenverlauf (46) an den Projektionsdatensatz (44, 48) angepasst wird, wobei anhand des angepassten Kurvenverlaufs (46) eine Bestimmung von Fehlern und/oder Defekten (42) der mindestens einen Fügeverbindung (18) durchgeführt wird.

3. Verfahren nach Anspruch 1 oder 2,
**dadurch gekennzeichnet,**
**dass** der Wirbelstromsensor (20) über eine Anzahl von benachbarten Fügeverbindungen (18) der Bauteile (4, 6) geführt wird, wobei ein gemeinsamer Projektionsdatensatz (48) als Maß für die räumliche Verteilung der Messsignale (32) entlang jeder Fügeverbindung (18) bestimmt wird.

4. Verfahren nach einem der Ansprüche 1 bis 3,
**dadurch gekennzeichnet,**
**dass** der Projektionsdatensatz (44, 48) mit einem hinterlegten Referenzdatensatz verglichen wird.

5. Verfahren nach einem der Ansprüche 1 bis 4,
**dadurch gekennzeichnet,**
**dass** der Wirbelstromsensor (20) bei aufeinanderfolgenden Bewegungen entlang der mindestens einen Fügeverbindung (18) verkippt und/oder verschwenkt wird.

6. Verwendung eines Verfahrens nach einem der Ansprüche 1 bis 5 zur Herstellung eines Batterieelements (2),
- wobei mindestens zwei benachbart angeordnete Batteriekomponenten (4, 6) mit einer Schweißverbindung gefügt werden, wobei mindestens eine Schweißnaht als Fügeverbindung (18) erzeugt wird, und
- wobei das Verfahren zur Charakterisierung der mindestens einen Fügeverbindung (18) verwendet wird.

7. Vorrichtung zur Herstellung eines Batterieelements (2), aufweisend
- eine Schweißeinrichtung (16) zur stoffschlüssigen Schweißverbindung von mindestens zwei übereinander gestapelt angeordnete Batteriekomponenten (4, 6), und
- einen Wirbelstromsensor (20) zur Erzeugung und Erfassung von Wirbelströmen im Bereich mindestens einer durch die Schweißeinrichtung erzeugten Fügeverbindung (18), welcher entlang der mindestens einen Fügeverbindung (18) bewegbar ist, sowie
- einen Controller (22) zur Durchführung eines Verfahrens nach einem der Ansprüche 1 bis 5.

8. Vorrichtung nach Anspruch 7,
**dadurch gekennzeichnet,**
**dass** der Wirbelstromsensor (20) als ein Gabelsensor in Transmissionsgeometrie ausgeführt ist.

## Claims

1. Method for characterizing at least one joined connection (18), in particular a weld seam, between at least two joined components (4, 6),
- wherein an eddy-current sensor (20) is moved several times in succession along the at least one joining joined connection (18), a plurality of data sets of the sensed measuring signals (32) being generated in different parallel sectional planes (34, 36, 38) of the joined connection (18),
- wherein the plurality of data sets are used to determine a projection data set (44, 48) as a measure of the spatial distribution of the measuring signals (32) along the at least one joined connection (18), and
- wherein the data sets are added in order to determine the projection data set (44, 48) along a direction (y) oriented perpendicular to the section planes (34, 36, 38).

2. Method according to claim 1,
**characterized in**
**that** a curve progression (46) is adapted to the projection data set (44, 48), wherein a determination of errors and/or defects (42) of the at least one joined connection (18) is carried out on the basis of the adapted curve progression (46).

3. Method according to claim 1 or 2,
**characterized in**
**that** the eddy-current sensor (20) is passed over a plurality of adjacent joined connections (18) of the components (4, 6), a shared projection data set (48) being determined as a measure of the spatial distribution of the measuring signals (32) along each joining joined connection (18).

4. Method according to one of claims 1 to 3,
**characterized in**
**that** the projection data set (44, 48) is compared with a stored reference data set.

5. Method according to one of claims 1 to 4,
**characterized in**
**that** the eddy-current sensor (20) is tilted and/or pivoted during consecutive movements along the at least one joined connection (18).

6. Use of a method according to one of claims 1 to 5 for manufacturing a battery element (2),
- wherein at least two adjacently arranged battery components (4, 6) are joined with a welded joint, wherein at least one weld seam is produced as a joined connection (18), and
- wherein the method is used to characterize the at least one joined connection (18).

7. Device for manufacturing a battery element (2), comprising
- a welding device (16) for the material-to-material welded connection of at least two battery components (4, 6) arranged so as to be stacked above each other, and
- an eddy-current sensor (20) configured to generate and detect eddy currents in the vicinity of at least one joined connection (18) created by the welding device, which can be moved along the at least one joined connection (18), as well as
- a controller (22) for carrying out a method according to one of claims 1 to 5.

8. Device according to claim 7,
**characterized in**
**that** the eddy-current sensor (20) is configured as a fork sensor in transmission geometry.

## Revendications

1. Procédé de caractérisation d'au moins un assemblage (18), notamment d'un cordon de soudure, entre au moins deux pièces (4, 6) assemblées,
- dans lequel un capteur à courants de Foucault (20) est guidé plusieurs fois de suite le long de l'au moins un joint d'assemblage (18), un certain nombre d'ensembles de données des signaux de mesure détectés (32) étant générés dans différents plans de coupe parallèles (34, 36, 38) du joint d'assemblage (18),
- dans lequel, à l'aide du nombre d'ensembles de données, un ensemble de données de projection (44, 48) est déterminé comme mesure de la répartition spatiale des signaux de mesure (32) le long de la au moins une jonction d'assemblage (18), et
- dans lequel les jeux de données sont additionnés pour déterminer le jeu de données de projection (44, 48) le long d'une direction (y) orientée perpendiculairement aux plans de coupe (34, 36, 38).

2. Procédé selon la revendication 1,
**caractérisé en ce**
**qu'**une allure de courbe (46) est adaptée à l'ensemble de données de projection (44, 48), une détermination d'erreurs et/ou de défauts (42) de l'au moins une jonction d'assemblage (18) étant effectuée à l'aide de l'allure de courbe (46) adaptée.

3. Procédé selon la revendication 1 ou 2,
**caractérisé en ce**
**que** le capteur à courants de Foucault (20) est guidé sur un certain nombre de jonctions d'assemblage (18) voisines des composants (4, 6), un jeu de données de projection (48) commun étant déterminé comme mesure pour la répartition spatiale des signaux de mesure (32) le long de chaque jonction d'assemblage (18).

4. Procédé selon l'une des revendications 1 à 3,
**caractérisé en ce**
**que** l'ensemble de données de projection (44, 48) est comparé à un ensemble de données de référence déposé.

5. Procédé selon l'une des revendications 1 à 4,
**caractérisé en ce**
**que** le capteur à courants de Foucault (20) est basculé et/ou pivoté lors de mouvements successifs le long de la au moins une jonction d'assemblage (18).

6. Utilisation d'un procédé selon l'une des revendications 1 à 5 pour la fabrication d'un élément de batterie (2),
- dans lequel au moins deux composants de batterie (4, 6) disposés de manière adjacente sont assemblés avec un joint soudé, au moins un cordon de soudure étant généré comme jonction d'assemblage (18), et
- dans lequel le procédé est utilisé pour caractériser ledit au moins une jonction d'assemblage (18).

7. Dispositif de fabrication d'un élément de batterie (2), comprenant
- un dispositif de soudage (16) pour l'assemblage par soudage par liaison de matière d'au moins deux composants de batterie (4, 6) empilés l'un sur l'autre, et
- un capteur à courants de Foucault (20) pour générer et détecter des courants de Foucault dans la zone d'au moins une jonction d'assemblage (18) généré par le dispositif de soudage, lequel peut être déplacé le long d'au moins une jonction d'assemblage (18), and
- un contrôleur (22) pour la mise en oeuvre d'un procédé selon l'une des revendications 1 à 5.

8. Dispositif selon la revendication 7,
**caractérisé en ce**
**que** le capteur à courants de Foucault (20) est réalisé sous la forme d'un capteur à fourche en géométrie de transmission.
